# EUROPÄISCHE PATENTSCHRIFT

(11) **EP 0 545 158 B1**
(45) Veröffentlichungstag und Bekanntmachung des Hinweises auf die Patenterteilung: **29.03.1995**
(21) Anmeldenummer: 92119739.8
(22) Anmeldetag: 19.11.1992
(51) Int. Cl.: H05K 9/00, H01R 4/30, F16B 19/10

(54) **Schraubeinrichtung**
Threading device
Dispositif à vis

(30) Priorität: 29.11.1991 DE 4139473
(43) Veröffentlichungstag der Anmeldung: 09.06.1993
(73) Patentinhaber: VERO Electronics GmbH, D-28279 Bremen (DE)
(72) Erfinder: Borschewski, Dietmar, W-2800 Bremen 1 (DE); Schröder, Rainer, W-2820 Bremen 77 (DE); Hornung, Gerd, W-2878 Wildeshausen (DE); Bösch, Peter, W-2800 Bremen 61 (DE)
(74) Vertreter: Bohnenberger, Johannes, Dr.

(56) Entgegenhaltungen:
- DE-A- 1 704 771
- DE-A- 3 612 501
- DE-B- 2 141 550
- FR-A- 1 340 169

## Beschreibung

Die Erfindung betrifft eine Schraubeinrichtung zum elektrisch leitenden und lösbaren Befestigen einer Frontplatte oder dgl. an einem Baugruppenträger oder Gehäuse nach dem Oberbegriff des Patentanspruches 1.

Bei Baugruppenträgern oder Gehäusen, insbesondere bei 19˝-Gehäusen, sieht man im allgemeinen abnehmbare Frontplatten, die oftmals in Einzelabschnitte unterteilt sind, zum Verschließen der Gehäusevorderseite vor. Diese Frontplatten werden vom Hersteller lediglich mit den Bohrungen oder Stanzlöchern zum Befestigen am Gehäuse versehen, damit der Anwender die für seinen Anwendungszweck notwendigen Bohrungen z. B. zur Aufnahme von Anzeige- oder Bedienungselementen anbringen kann. Die fertigen Frontplatten werden vom Hersteller passiviert, also mit einer Schutzschicht versehen, so daß sie korrosionsfest sind. Derartige Schichten, z. B. beim hier üblichen Werkstoff Aluminium eine Eloxalschicht, sind im allgemeinen schlecht oder gar nicht elektrisch leitend. Man muß also, um eine elektrische Abschirmwirkung des Gehäuses auch im Bereich der Frontplatten zu erzielen, insbesondere bei EMV-Gehäusen besondere Maßnahmen vorsehen, um die Frontplatten in eine elektrisch leitende Verbindung mit dem (übrigen) Gehäuse zu bringen.

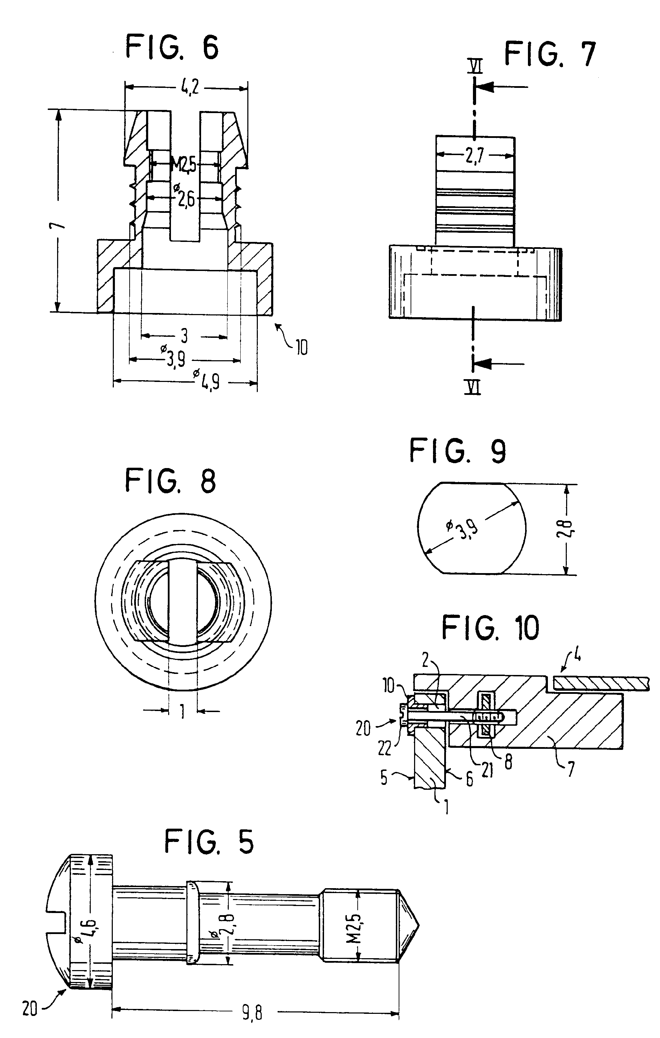

Zu diesem Zweck ist die in Fig. 10 gezeigte Anordnung bekannt. Hierbei wird eine Hülse 10 aus Metall in eine Öffnung 2 in der Frontplatte 1 mittels eines Werkzeugs so eingepreßt, daß sie mit ihrem Außenumfang in eine feste, leitende Verbindung mit der Frontplatte 1 gelangt. Die Hülse 10 ist hierbei z. B. gerändelt, so daß beim Einpressen die Eloxalschicht durchschnitten und der elektrische Kontakt sichergestellt wird.

Schraubt man nun die Frontplatte 1 mittels einer Schraube 20 am Gehäuse 4 fest, so daß ihr Gewindeschaft 21 in der Gewindebohrung eines Gewindestreifens 8 sitzt, so drückt der Kopf 22 der Schraube 20 auf die Außenfläche der Hülse 10 und verbindet so die Frontplatte 1 elektrisch leitend mit dem Gewindestreifen 8, der wiederum durch hier nicht näher zu erläuternde Maßnahmen mit einem Rahmen 7 des Gehäuses 4 in elektrisch leitender Verbindung steht. Dadurch ist die Verbindung zwischen Frontplatte 1 und Gehäuse 4 sichergestellt.

Ein Problem hierbei liegt darin, daß die Hülse 10 nicht ohne Werkzeug in die Öffnung 2 so fest eingepreßt werden kann, daß die elektrisch leitende Verbindung durch Auftrennen der Eloxalschicht auf der Innenwand der Öffnung 2 sichergestellt ist. Dieser Werkzeug-Aufwand ist selbst schon nachteilig.

Wenn nun aber der Hersteller der Gehäusebauteile die Frontplatte 1 bereits mit Hülsen 10 ausstattet, so stehen diese über die Außenseite 5 der Frontplatte 1 hervor, so daß die Bearbeitung der Frontplatte beim Anwender erschwert wird. Somit muß jeder Anwender, der einerseits diesen Nachteil nicht in Kauf nehmen, andererseits aber auf die elektrisch leitende Verbindung nicht verzichten will, ein solches Werkzeug haben.

Der Erfindung liegt die Aufgabe zugrunde, eine Schraubeinrichtung der eingangs genannten Art dahingehend weiterzubilden, daß in einfacher Weise eine sichere elektrisch leitende Verbindung zwischen der Frontplatte und dem Gehäuse sichergestellt wird.

Diese Aufgabe wird durch die im Kennzeichen des Patentanspruches 1 angegebenen Merkmale gelöst.

Ein wesentlicher Punkt der Erfindung liegt darin, daß die elektrisch leitende Verbindung zwischen der Hülse und der Frontplatte erst dann geschaffen bzw. vervollständigt wird, wenn die Frontplatte festgeschraubt wird, wobei die beim Festschrauben mittels des ohnehin notwendigen Schraubendrehers auftretenden hohen Kräfte für den eigentlichen Kontaktierungsvorgang nutzbar gemacht werden. Ein gesondertes Werkzeug entfällt aus diesem Grund.

Die Hülse selbst kann man nun so leicht deformierbar machen bzw. auch entsprechend dimensionieren, daß sie von Hand in die Öffnung in der Frontplatte einsetzbar ist. Bei einer entsprechenden Materialwahl wird dann die Hülse beim Aufweiten (durch das Festschrauben) derart plastisch verformt, daß der elektrische Kontakt bzw. feste Sitz auch bei Lösen der Schraubverbindung bestehen bleibt.

Zur Sicherstellung der elektrisch leitenden Verbindung ist es von Vorteil, wenn gesonderte Schneideinrichtungen an der Hülse dort von ihrem Außenumfang hervorspringend vorgesehen sind, wo sie Kontakt zur Frontplatte bilden sollen. Dies kann vorteilhafterweise durch konzentrisch zur Hülse auf diese aufgedrehte Rippen mit im wesentlichen dreieckigem Querschnitt geschehen.

Zum leichteren Verformen der Hülse ist es von Vorteil, wenn diese einen (vorzugsweise zwei) ihre Mantelfläche durchtrennenden Schlitz aufweist, den man vom vorderen Ende, also von dem Ende, mit welchem die Hülse in die Öffnung eingesetzt wird, in die Hülse einsägt.

Das Einstecken der Hülse in die Öffnung wird dann erleichtert, wenn sie an ihrem Vorderende mit einem sich nach vorne verjüngenden Außenkonus versehen ist. Vorteilhafterweise weist dieser an seinem hinteren, dickeren Ende einen nach innen springenden Absatz zur Bildung einer Schulter auf, so daß man beim Einstecken der Hülse in die Öffnung diese zuerst (elastisch) zusammendrückt, während sie sich dann, in ganz eingedrücktem Zustand, wieder aufweitet, so daß die Schulter auf der Innenseite der Frontplatte in Anlage gelangt und die Hülse gegen ein Herausziehen gesichert ist.

Vorzugsweise weist die Schraube zwischen ihrem Gewindeschaft bzw. Gewinde-Abschnitt und dem zweiten Spreizabschnitt einen verjüngten Abschnitt auf, wobei gleichzeitig in der Innenbohrung der Hülse ein nach innen vorspringender korrespondierender Gewindeabschnitt derart angebracht ist, daß die Schraube mit ihrem Gewindeschaft durch den Gewindeabschnitt vollständig hindurchgeschraubt werden kann, bevor die Spreizabschnitte auf der Schraube bzw. in der Hülse miteinander in Eingriff gelangen. So kann die Schraube unverlierbar mit der Hülse und damit mit der Frontplatte verbunden werden, ist aber noch frei beweglich, da der verjüngte Abschnitt mit hinreichend Spiel zum Gewindeabschnitt in der Hülse ausgestattet ist.

Der in der Hülse vorgesehene erste Spreizabschnitt weist vorzugsweise einen konischen Abschnitt auf, der von einem hülsenäußeren zylindrischen Abschnitt größeren Durchmessers zu einem hülseninneren zylindrischen Abschnitt geringeren Durchmessers überleitet. Wenn nun die Schraube in die Hülse hineingezogen wird, so gelangt ihr Spreizabschnitt zunächst mit dem konischen Abschnitt in Kontakt und weitet die Hülse auf. Sobald die konische Fläche "überwunden" ist, gelangt der Spreizabschnitt auf der Schraube in den zylindrischen Abschnitt in der Hülse, so daß ein weiteres Hineinwandern der Schraube in die Hülse möglich ist, ohne daß diese exzessiv aufgeweitet oder die Schraube gar festgeklemmt wird, bevor ihr Kopf auf der Außenfläche der Hülse aufsitzt.

Dieser Vorgang wird dann (hinsichtlich der notwendigen Kräfte) erleichtert, wenn der Spreizabschnitt auf der Schraube ringwulstförmig ausgebildet ist, so daß nur eine kleine, im wesentlichen (kreis-) linienförmige Fläche des Spreizabschnitts auf der Schraube mit dem Spreizabschnitt in der Hülse in Verbindung steht.

Bevorzugte Ausführungsformen der Erfindung ergeben sich aus den Unteransprüchen.

Nachfolgend wird ein Ausführungsbeispiel der Erfindung anhand von Abbildungen näher erläutert. Hierbei zeigen:
- Fig. 1 - 4: verschiedene Zusammenbaustadien einer Ausführungsform der Erfindung im Teilschnitt,
- Fig. 5: die Seitenansicht einer Schraube,
- Fig. 6: einen Längsschnitt der Hülse,
- Fig. 7: eine Seitenansicht der Hülse,
- Fig. 8: eine Vorderansicht der Hülse,
- Fig. 9: eine Draufsicht auf eine Frontplattenöffnung, und
- Fig. 10: einen Querschnitt durch eine bekannte Schraubeinrichtung.

Die hier gezeigte Ausführungsform der erfindungsgemäßen Schraubeinrichtung besteht aus zwei Teilen, einer Hülse 10 und einer Schraube 20.

Die Hülse 10 weist eine topfförmige Kopfaufnahme 14 auf, in welche ein Kopf 22 der Schraube 20 mit geringem Spiel aufnehmbar ist.

In die Kopfaufnahme 14 mündet eine die Hülse 10 konzentrisch durchsetzende Innenbohrung 11. Die Innenbohrung 11 umfaßt, ausgehend von der Kopfaufnahme 14, also vom Hinterende der Hülse 14, eine zylindrische, erweiterte Bohrung 16, die über einen konischen Abschnitt 15 auf eine engere Bohrung 13 reduziert wird. Der Innenkonus 15 und der engere Abschnitt 13 bilden zusammen einen ersten Spreizabschnitt der Hülse 10.

Anschließend an den engeren, zylindrischen Abschnitt 13 ist ein in die Bohrung 11 vorspringender Innengewindeabschnitt 17 vorgesehen. Nach dem Innengewindeabschnitt 17 erweitert sich die Bohrung 11 wieder auf einen zylindrischen Endabschnitt.

In ihrem Außenumfang weist die Hülse 10 bei der Kopfaufnahme 14 ihren größten Durchmesser auf, wobei die Kopfaufnahme 14 eine Anlageschulter 14′ bildet, die mit einer Außenseite 5 einer Frontplatte 11 in zusammengebautem Zustand der Schraubeinrichtung in Anlage kommen kann.

Nach der Kopfaufnahme 14 weist die Hülse einen im wesentlichen zylindrischen Außendurchmesser auf, von welchem nach außen hervorspringend Schneidrippen 25 mit im wesentlichen dreieckigem Querschnitt angedreht sind. Dieser zylindrische Abschnitt geht über eine Schulter 9 sprungförmig in das dickere, hintere Ende eines Außenkonus 19 über, dessen dünneres Vorderende einen Außendurchmesser aufweist, der unterhalb des Außendurchmessers des zylindrischen Kontaktabschnitts 12 zwischen der Kopfaufnahme 14 und der Schulter 9 liegt. Dieser vordere Enddurchmesser der Hülse 10 bzw. des Konus 19 ist so dimensioniert, daß man die Hülse 10 leicht in eine Öffnung 2 der Frontplatte 1 einsetzen kann. Der Außendurchmesser des Konus 19 kurz vor der Schulter 9 ist jedoch größer als die Weite der Öffnung 2, während der Kontaktabschnitt 12 wiederum einen Durchmesser derart aufweist, daß die Spitzen der Schneidrippen 25 im wesentlichen konturengleich mit der Öffnung 2 im Bereich der Außenseite 5 der Frontplatte 1 sind.

Die Hülse 10 weist einen quer zu ihrer Längsachse verlaufenden durchgehenden Schlitz 18 auf, der sich vom Vorderende der Hülse bis im wesentlichen zur Anlageschulter 14′ erstreckt.

Der Kopf der Schraube 22 weist auf seiner Innenseite eine Anlagefläche 22′ auf, welche der Auflagefläche in der Kopfaufnahme 14 der Hülse 10 entspricht.

Nach dem Kopf 22 wird der Schaft 21 der Schraube 20 zunächst von einem zylindrischen Abschnitt 27 gebildet, dessen Außendurchmesser geringer ist als der Innendurchmesser des zylindrischen Hülsenabschnitts 13 mit verjüngtem Durchmesser. Der zylindrische Abschnitt 27 endet in einem nach außen vorspringenden Ringwulst 23, der einen zweiten Spreizabschnitt bildet. Der Ringwulst 23 weist einen im wesentlichen 1/4-kreisförmigen Querschnitt auf, wobei die abgerundete Seite zum Vorderende der Schraube zeigt.

Nach dem Spreizabschnitt 23 wird der Schaft 21 der Schraube 20 durch einen zylindrischen Abschnitt 24 mit verjüngtem Durchmesser fortgesetzt, der in einen Außen-Gewindeschaft 21 übergeht, wobei das Außengewinde einen größeren Durchmesser hat als der verjüngte Abschnitt 24 und passend zum Gewindeabschnitt 17 in der Hülse 10 geformt ist. An seinem Ende ist der Schaft 21 mit einer angedrehten Spitze versehen, die ein erleichtertes Einsetzen in Gewindelöcher ermöglichen soll.

Die einzelnen Maße der Schraube, der Hülse und der Öffnung 2 in der Frontplatte 1 sind in den Fig. 5-9 angegeben, aus denen auch hervorgeht, daß die Öffnung 2 einen tonnenförmigen Querschnitt aufweist, so daß (demzufolge) die Hülse 10 auf ihrer Außenfläche bis auf die Kopfaufnahme 14 zweiseitig abgeflacht ist. Die flachen Seiten liegen senkrecht zum Schlitz 18. Dadurch ist eine erleichterte Verformbarkeit der Hülse sichergestellt.

Im folgenden wird der Zusammenbau der Schraubeinrichtung erläutert.

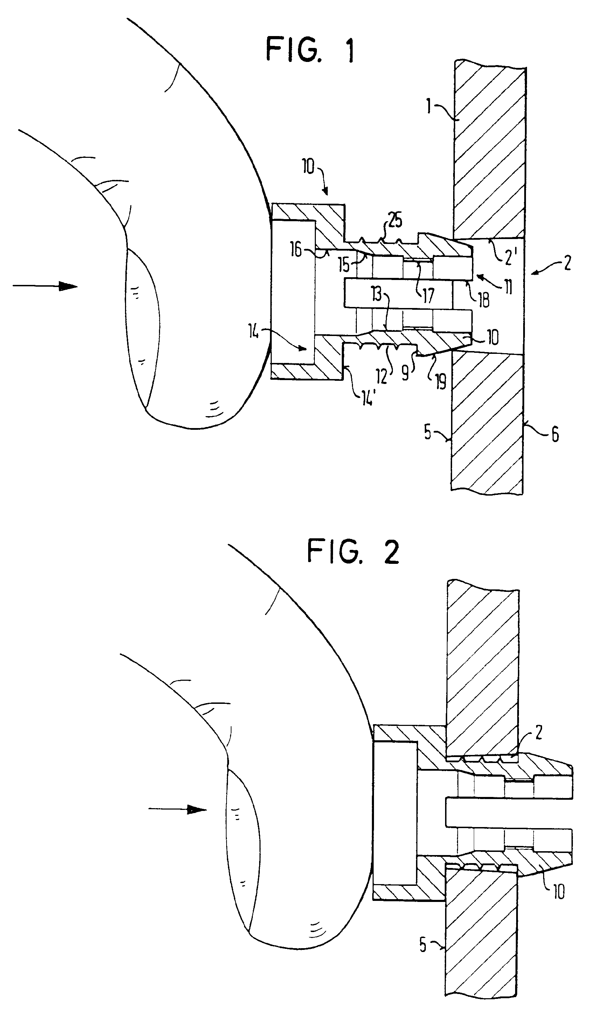

Wie in Fig. 1 gezeigt, setzt man von Hand eine Hülse 10 in die Öffnung 2 der Frontplatte 1 ein und drückt die Hülse 10 dann in die Öffnung 2, bis die Kopfaufnahme 14 mit ihrer Anlageschulter 14′ auf der Außenseite 5 der Frontplatte 1 aufliegt. Hierbei wird die Hülse 10 zusammengedrückt, was durch den Schlitz 18 ermöglicht wird. Im eingedrückten Zustand schnappt dann die Hülse wieder auf, so daß die Schulter 9 mit der Innenseite 6 der Frontplatte 1 in Eingriff gelangt. In diesem Zustand (Fig. 2) ist die Hülse 10 bereits in der Frontplatte 1 gesichert und kann nicht mehr herausfallen.

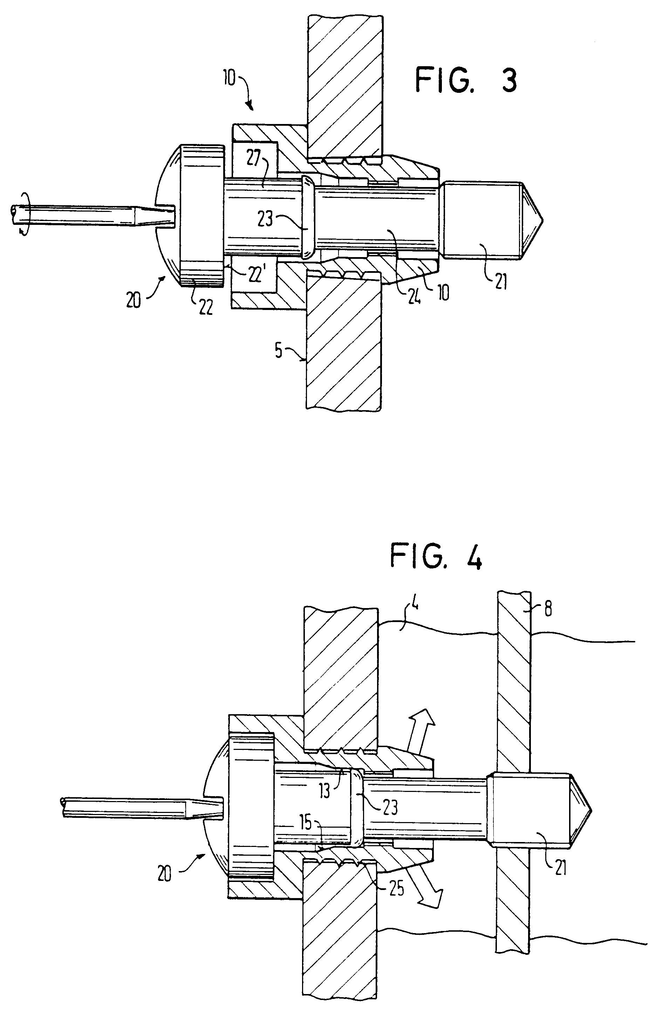

Nun setzt man eine Schraube 20 in die Hülse 10 ein und dreht (mit einem schematisiert dargestellten Schraubendreher) den Gewindeschaft 21 durch den Innengewindeabschnitt 17 ganz hindurch, so daß die Schraube 20 die in Fig. 3 gezeigte Position einnimmt, bei welcher sich der verjüngte Abschnitt 24 im Bereich des Innengewindes 17 befindet. In diesem Zustand ist die Schraube 20 unverlierbar mit der in der Frontplatte 1 fixierten Hülse mit Spiel verbunden.

Setzt man nun die Frontplatte 1 auf ein nur teilweise dargestelltes Gehäuse 4 auf, so kann man die Schraube 20 mit ihrem Gewindeschaft 21 in eine der Gewindebohrungen eines im Gehäuse 4 sitzenden Gewindestreifens 8 einschrauben.

Bei diesem Einschraubvorgang wird nun der wulstförmige zweite Spreizabschnitt 23 der Schraube 20 zunächst durch den Innenkonus 15 gezogen, wobei die Hülse 10 aufgeweitet wird, wie dies in Fig. 4 mit Pfeilen dargestellt ist. Diese Aufweitung geschieht so lange, bis der zweite Spreizabschnitt 23 in den zylindrischen Abschnitt 13 mit geringerem Durchmesser gelangt. Nun kann die Schraube 20 zwar weiter eingedreht werden, bis die in Fig. 4 gezeigte Endposition erreicht ist, bei welcher die Anlagefläche 22′ in der Kopfaufnahme 14 in Anlage kommt, eine weitere Aufweitung geschieht hier aber nicht mehr.

Beim Aufweitungsvorgang drücken sich die Schneidrippen 25 durch die auf der Innenfläche 2′ aufgebrachte Passivierungsschicht (Eloxalschicht) und schneiden in das Material der Frontplatte 1 hinein. Dadurch wird ein sicherer elektrischer Kontakt zwischen dem Material der Hülse 10 und der Frontplatte 1 bewerkstelligt. Der Aufweitungsvorgang ist teilweise irreversibel (plastisch), was durch eine entsprechende Materialwahl für die Hülse 10 (z. B. Messing) sichergestellt werden kann. Dadurch ist gewährleistet, daß bei erneutem Lösen der Schraube 20 aus dem Gewindestreifen 8 im wesentlichen die in Fig. 4 gezeigte Konfiguration beibehalten bleibt, wobei der sichere Anpreßdruck bei erneutem Einschrauben immer gewährleistet bleibt.

### Bezugszeichenliste

- 1: Frontplatte
- 2: Öffnung
- 2′: Innenfläche
- 3: Gewindebohrung
- 4: Gehäuse
- 5: Außenseite
- 6: Innenseite
- 7: Rahmen
- 8: Gewindestreifen
- 9: Schulter
- 10: Hülse
- 11: Innenbohrung
- 12: Kontaktabschnitt
- 13: zylindrischer Abschnitt
- 14: Kopfaufnahme
- 14′: Anlageschulter
- 15: Innenkonus
- 16: erweiterte Bohrung
- 17: Gewindeabschnitt
- 18: Schlitz
- 19: Außenkonus
- 20: Schraube
- 21: Schaft
- 22: Kopf
- 22′: Anlagefläche
- 23: zweiter Spreizabschnitt
- 24: verjüngter Abschnitt
- 25: Schneidrippe
- 27: zylindrischer Abschnitt.

## Patentansprüche

1. Schraubeinrichtung zum elektrisch leitenden, lösbaren Befestigen einer Frontplatte an einem elektrisch leitenden Baugruppenträger oder Gehäuse für elektrische Baugruppen, insbesondere für 19˝-Gehäuse, umfassend
eine elektrisch leitende Hülse (10), die in eine Öffnung (2) in einer Frontplatte (1) unter Schaffung einer elektrisch leitenden Verbindung zwischen der Frontplatte (1) und der Hülse (10) einsetzbar ist, und
eine Schraube (20), deren Gewindeschaft (21) durch eine Innenbohrung (11) der Hülse (10) hindurchführbar und in einer Gewindebohrung (3) am Gehäuse (4) so einschraubbar ist, daß ein Kopf (22) der Schraube (20) auf der Hülse (10) aufliegt und eine elektrisch leitende Verbindung von der Gewindebohrung (3) über den Gewindeschaft (21), den Kopf (22) und die Hülse (10) zur Frontplatte (1) sichergestellt wird,
**dadurch gekennzeichnet,** daß
die Hülse (10) in einem in die Öffnung (2) einführbaren Kontaktabschnitt (12) aufweitbar ist und einen in die Innenbohrung (11) vorspringenden ersten Spreizabschnitt (13, 15) aufweist, und daß der Gewindeschaft (21) einen über seinen Außenumfang hervorspringenden zweiten Spreizabschnitt (23) aufweist, der mindestens dann, wenn der Kopf (22) auf der Hülse (10) aufliegt, die Hülse (10) über den ersten Spreizabschnitt (13, 15) derart aufweitet, daß die Hülse (10) mit ihrer Außenfläche im Bereich des Kontaktabschnitts (12) mit der Frontplatte (1) in der Öffnung (2) in elektrisch leitende Verbindung gelangt.

2. Schraubeinrichtung nach Anspruch 1,
**dadurch gekennzeichnet,** daß die Hülse (10) am Kontaktabschnitt (12) Schneideinrichtungen (25) aufweist.

3. Schraubeinrichtung nach Anspruch 2,
**dadurch gekennzeichnet,** daß die Schneideinrichtungen im wesentlichen konzentrisch zur Hülse (10) angeordnete Rippen (25) mit im wesentlichen dreieckigem Querschnitt umfassen.

4. Schraubeinrichtung nach einem der vorhergehenden Ansprüche,
**dadurch gekennzeichnet,** daß die Hülse (10) mindestens einen ihre Mantelfläche durchtrennenden Schlitz (18) zur Erleichterung des Aufweitens aufweist.

5. Schraubeinrichtung nach einem der vorhergehenden Ansprüche,
**dadurch gekennzeichnet,** daß die Hülse (10) an ihrem Vorderende einen sich verjüngenden Außenkonus (19) aufweist.

6. Schraubeinrichtung nach Anspruch 5,
**dadurch gekennzeichnet,** daß der Außenkonus (19) hinter seinem dickeren Ende einen nach innen springenden Absatz zur Bildung einer Schulter (9) aufweist, welche die eingesteckte Hülse (10) an einer Innenseite (6) der Frontplatte (1) gegen ein Herausziehen sichert.

7. Schraubeinrichtung nach einem der vorhergehenden Ansprüche,
**dadurch gekennzeichnet,** daß die Schraube (20) zwischen dem Gewindeschaft (21) und dem zweiten Spreizabschnitt (23) einen verjüngten Abschnitt (24) aufweist, und daß in der Innenbohrung (11) der Hülse (10) ein nach innen vorspringender korrespondierender Gewindeabschnitt (17) derart angebracht ist, daß die Schraube (20) mit ihrem Gewindeschaft (21) durch den Gewindeabschnitt (17) vollständig hindurchschraubbar ist, ohne daß der erste und der zweite Spreizabschnitt (13, 15; 23) miteinander in Eingriff gelangen.

8. Schraubeinrichtung nach einem der vorhergehenden Ansprüche,
**dadurch gekennzeichnet,** daß der erste Spreizabschnitt einen mit dem zweiten Spreizabschnitt (23) der Schraube (20) zuerst in Eingriff gelangenden, sich im wesentlichen konisch verengenden Abschnitt (15) und einen darauffolgenden im wesentlichen zylindrischen Abschnitt (13) umfaßt.

9. Schraubeinrichtung nach einem der vorhergehenden Ansprüche,
**dadurch gekennzeichnet,** daß der zweite Spreizabschnitt (23) im wesentlichen ringwulstförmig ausgebildet ist.

## Claims

1. Screw device for fastening a front panel in an electrically conductive, detachable manner to an electrically conductive subrack or housing for electrical assembly groups, in particular for 19˝ enclosures, comprising
an electrically conductive sleeve (10) which is insertable into an opening (2) in a front panel (1), simultaneously establishing an electrically conductive connection between the front panel (1) and the sleeve (10), and
a screw (20), whose threaded shaft (21) may be passed through an internal bore (11) of the sleeve (10) and be screwed in a tapped bore (3) of the housing (4) in such a way that a head (22) of the screw (20) rests against the sleeve (10) and an electrically conductive connection from the tapped bore (3) via the threaded shaft (21), the head (22) and the sleeve (10) to the front panel (1) is ensured,
characterized in that the sleeve (10) in a contact portion (12), which may be introduced into the opening (2), is expandable and has a first expansion portion (13, 15) projecting into the internal bore (11), and that the threaded shaft (21) has, projecting beyond its outer periphery, a second expansion portion (23) which at least when the head (22) is resting against the sleeve (10) expands the sleeve (10) by means of the first expansion portion (13, 15) in such a way that the sleeve (10) comes with its outer surface in the region of the contact portion (12) into electrically conductive connection with the front panel (1) in the opening (2).

2. Screw device according to claim 1,
characterized in that the sleeve (10) has cutting devices (25) on the contact portion (12).

3. Screw device according to claim 2,
characterized in that the cutting devices comprise ribs (25) which are disposed substantially concentrically relative to the sleeve (10) and are substantially triangular in cross-section.

4. Screw device according to one of the preceding claims,
characterized in that the sleeve (10) for facilitating expansion has at least one slot (18) cutting through its lateral surface.

5. Screw device according to one of the preceding claims,
characterized in that the sleeve (10) at its front end has a tapering external cone (19).

6. Screw device according to claim 5,
characterized in that the external cone (19) behind its thicker end has an inwardly projecting recess to form a shoulder (9), which secures the inserted sleeve (10) against an inner side (6) of the front panel (1) and prevents the sleeve from being pulled out.

7. Screw device according to one of the preceding claims,
characterized in that the screw (20) has a reduced portion (24) between the threaded shaft (21) and the second expansion portion (23), and that in the internal bore (11) of the sleeve (10) an inwardly projecting, correspondingly tapped portion (17) is provided in such a way that the screw (20) may be screwed with its threaded shaft (21) fully through the tapped portion (17) without the first and the second expansion portions (13, 15; 23) coming into engagement with one another.

8. Screw device according to one of the preceding claims,
characterized in that the first expansion portion comprises a substantially conically narrowing portion (15), which is first to come into engagement with the second expansion portion (23) of the screw (20), and a subsequent, substantially cylindrical portion (13).

9. Screw device according to one of the preceding claims,
characterized in that the second expansion portion (23) substantially takes the form of an annular ring.

## Revendications

1. Dispositif de vissage pour la fixation amovible, électriquement conductrice, d'une plaque frontale sur un support de composants électriquement conducteur ou un boîtier pour composants électriques, un boîtier 19˝ notamment, comportant une douille (10) électriquement conductrice, qui peut être logée dans une ouverture (2) d'une plaque frontale (1), en créant une liaison électrique conductrice entre la plaque frontale (1) et la douille (10), ainsi qu'une vis (20), dont la tige filetée (21) peut être introduite au travers d'un alésage interne (11) de la douille (10) et être vissée dans un taraudage (3) du boîtier (4), de sorte qu'une tête (22) de la vis (20) s'applique sur la douille (10), et qu'une liaison conductrice électrique est garantie entre le taraudage (3) et la plaque frontale (1), par l'intermédiaire de la tige filetée (21), de la tête (22) et de la douille (10), caractérisé en ce que la douille (10) peut être élargie dans une section de contact (12), introduite dans l'ouverture (2), et présente une première section d'écartement (13, 15) en saillie dans l'alésage interne (11), et en ce que la tige filetée (21) présente une seconde section d'écartement (23), en saillie sur son pourtour externe, qui élargit la douille (10) par l'intermédiaire de la première section d'écartement (13, 15), lorsque la tête (22) s'applique sur la douille (10), au moins, de sorte que la douille (10) entre en liaison conductrice électrique par sa surface externe avec la plaque frontale (1) dans l'ouverture (2), dans la zone de la section de contact (12).

2. Dispositif de vissage suivant la revendication 1, caractérisé en ce que la douille (10) présente des dispositifs de coupe (25) sur la section de contact (12).

3. Dispositif de vissage suivant la revendication 2, caractérisé en ce que les dispositifs de coupe comportent des nervures (25) de section transversale essentiellement triangulaire, disposées d'une manière essentiellement concentrique par rapport à la douille (10).

4. Dispositif de vissage suivant l'une quelconque des revendications précédentes, caractérisé en ce que la douille (10) présente une fente (18), au moins, traversant sa surface d'enveloppe, en vue de faciliter l'élargissement.

5. Dispositif de vissage suivant l'une quelconque des revendications précédentes, caractérisé en ce que la douille (10) présente, sur son extrémité avant, un cône externe (19) rétréci.

6. Dispositif de vissage suivant la revendication 5, caractérisé en ce que le cône externe (19) présente, en arrière de son extrémité plus épaisse, un décrochement en saillie interne pour former un épaulement (9), qui bloque la douille (10) emmanchée, contre tout risque de retrait, sur une face interne (6) de la plaque frontale (1).

7. Dispositif de vissage suivant l'une quelconque des revendications précédentes, caractérisé en ce que la vis (20) présente une section rétrécie (24), entre la tige filetée (21) et la seconde section d'écartement (23), et en ce qu'une section taraudée (17) correspondante, en saillie interne, est prévue dans l'alésage interne (11) de la douille (10), de sorte que la vis (20) peut être intégralement vissée par sa tige filetée (21) au travers de la section taraudée (17), sans que la première et la seconde section d'écartement (13, 15; 23) n'entrent en prise mutuelle.

8. Dispositif de vissage suivant l'une quelconque des revendications précédentes, caractérisé en ce que la première section d'écartement comporte une section (15) essentiellement rétrécie en cône, entrant d'abord en prise avec la seconde section d'écartement (23) de la vis (20), et une section consécutive (13) essentiellement cylindrique.

9. Dispositif de vissage suivant l'une quelconque des revendications précédentes, caractérisé en ce que la seconde section d'écartement (23) est essentiellement réalisée en forme de bourrelet annulaire.
